# EUROPEAN PATENT APPLICATION

(11) **EP 4 564 409 A1**
(43) Date of publication of application: **04.06.2025**
(21) Application number: 23213527.7
(22) Date of filing: 30.11.2023
(51) Int. Cl.: H01L 21/67

(54) **PICK-AND-PLACE APPARATUS**

(71) Applicant: Nexperia B.V., 6534 AB Nijmegen (NL)
(72) Inventor: van der Veen, Gijs, Nijmegen (NL); Stokkermans, Joep, Nijmegen (NL); Wesselingh, Jasper, Nijmegen (NL); Kuipers, Johannes Josinus, Nijmegen (NL)
(74) Representative: Pjanovic, Ilija

(57) **Abstract**

Aspects of the present disclosure relate to a pick-and-place apparatus and method for transferring an electronic component from a donor substrate towards an acceptor substrate.

The pick-and-place apparatus in accordance with embodiments of the present disclosure comprises a movable transfer module that includes at least one pickup tool, wherein each pickup tool is configured for picking up an electronic component and comprises a tool body having a first surface. The pick-and-place apparatus further comprises a drive unit that is mechanically coupled to the movable transfer module and that is configured for moving the transfer module. The pick-and-place apparatus additionally comprises a liquid droplet unit to provide, for each pickup tool, at least one droplet of a liquid on the first surface of that pickup tool for allowing an electronic component released from the donor substrate to be captured and held by said at least one droplet of liquid on said first surface.

## Description

### FIELD

Aspects of the present disclosure relate to a pick-and-place apparatus and method for transferring an electronic component from a donor substrate towards an acceptor substrate. Aspects of the present disclosure particularly relate to pick-and-place apparatuses and methods for transferring electronic components such as semiconductor dies, either from a diced wafer or from a structured wafer, or packaged devices comprising one or more semiconductor dies.

### BACKGROUND

Pick-and-place apparatuses and methods for transferring an electronic component from a donor substrate towards an acceptor substrate are known in the art. An example of a known apparatus comprises a movable transfer module that includes at least one pickup tool, wherein each pickup tool is configured for picking up an electronic component. The pickup tool uses vacuum to capture and hold an electronic component that has been released from the donor substrate. The apparatus further comprises a drive unit that is mechanically coupled to the movable transfer module and that is configured for moving the transfer module. The pickup tool comprises a tool body with a narrow channel through which vacuum can be applied for attracting and holding an electronic component.

The positioning of the electronic component on the pickup tool during transfer is fixed as the electronic component is firmly pulled against the tool body. The position and orientation of the electronic components relative to the pickup tool is subject to variation. Consequently, when the electronic component is released from the pickup tool and is transferred to the acceptor substrate, the position and orientation of the electronic component on the acceptor substrate may vary.

In prior art systems, the abovementioned variation in position and orientation of the electronic component on the acceptor substrate can be partially addressed by inspecting the position of the electronic component relative to the pickup tool using an optical camera and to move the acceptor substrate prior to receiving the electronic component to partially compensate for a positional offset of the electronic component relative to the pickup tool. The movement of the acceptor substate is performed in dependence of the readout by the optical camera.

The Applicant has found that pick-and-place apparatuses of the type describe above present several disadvantages. Firstly, the throughput of the pick-and-place apparatuses can be hampered by the relatively slow switching speeds for switching the vacuum. Secondly, use of vacuum is less suitable for transferring small electronic components. Thirdly, as most acceptor stages used for holding and moving the acceptor substrates only allow a translational movement of the acceptor substrate, it is impossible or difficult to correct rotational offsets of the electronic component relative to the pickup tool.

### SUMMARY

According to an aspect of the present disclosure, a pick-and-place apparatus is provided that addresses at least one of the abovementioned drawbacks. According to an aspect of the present disclosure, this object is achieved by a pick-and-place apparatus that comprises a movable transfer module. This module comprises at least one pickup tool, wherein each pickup tool is configured for picking up an electronic component and comprises a tool body having a first surface. The apparatus further comprises a drive unit that is mechanically coupled to the movable transfer module and that is configured for moving the transfer module. The apparatus also includes a liquid droplet unit to provide, for each pickup tool, at least one droplet of a liquid on the first surface of that pickup tool for allowing an electronic component released from the donor substrate to be captured and held by said at least one droplet of liquid on said first surface.

According to aspects of the present disclosure, a liquid instead of a vacuum is used for holding the electronic component. The Applicant has found that by using a liquid, smaller devices can be efficiently transferred. Furthermore, delays associated with switching the vacuum on or off can be avoided, thereby improving the throughput of the apparatus.

The apparatus may further comprise a first release unit for releasing an electronic component from the donor substrate, and a controller for controlling the liquid droplet unit, the drive unit, and the first release unit. The first release unit may comprise a light source, such as a laser. As an example, the donor substrate may comprise a film frame carrier in which a foil or film is clamped on which a structured or diced semiconductor wafer is arranged. The semiconductor dies can be attached to the film or foil using a light-sensitive or heat-sensitive adhesive that loses its adhesive properties when illuminated using light of suitable intensity and/or wavelength.

Alternatively, the first release unit may comprise a mechanical release unit, such as a movable needle, that is configured to engage the electronic component to thereby release it from the donor substrate. For example, the first release unit may comprise a needle that can be driven by an actuator, such as a pneumatic cylinder. The needle can be used to engage and push an electronic component away from the donor substrate.

The controller can be configured to control the liquid droplet unit to provide at least one droplet of a liquid on the first surface of a given pickup tool among said at least one pickup tool, to control the drive unit to bring said given pickup tool into alignment with an electronic component to be released on the donor substrate, and to control the first release unit for releasing said electronic component. A typical order of events is that the at least one droplet of liquid is provided onto the first surface before the pickup tool is brought into alignment with an electronic component to be released. Typically, aligning the pickup tool with the electronic component to be released comprises bringing the pickup tool and donor substate into close proximity of one another leaving little space for providing the at least one droplet of liquid onto the first surface.

The controller can be configured to control the drive unit to bring said given pickup tool into alignment with an empty placement position on the acceptor substrate thereby allowing the electronic component, which is held on the first surface of said given pickup tool by the at least one droplet of liquid, to be transferred from said pickup tool to the empty placement position on the acceptor substrate.

The drive unit can be configured to rotate the transfer module about a rotational axis. The at least one pickup tool can each be configured to pick up an electronic component from a direction that is perpendicular to said rotational axis. For example, the movable transfer module may have a cylindrical body of which an axial axis coincides with said rotational axis, and wherein each pickup tool is mounted to the cylindrical body. For example, the at least one pickup took may comprise a plurality of pickup tools distributed at different angular positions on or in the cylindrical body, preferably with the same axial position.

Each pickup tool may comprise a plurality of electrodes disposed in or on its tool body at or near its first surface. The pick-and-place apparatus may further comprise a supply unit for applying a potential difference over at least one pair of electrodes among the plurality of electrodes for the purpose of shaping and/or moving the at least one droplet of liquid on said first surface. By applying a potential difference, an electric field can be generated at the first surface and inside the at least one droplet. This electric field can be used to shape, move, and/or orient the at least one droplet based on electrowetting and to thereby change the position and/or orientation of the electronic component relative to the pickup tool. To this end, the tool body may comprise a first body part and a second non-conductive hydrophobic body part. The second non-conductive hydrophobic body part is connected on a first side thereof to the first body part, while a second side thereof forms the first surface. The plurality of electrodes can be arranged on the first body part close to the first surface or in between the first body part and second non-conductive hydrophobic body part. The second non-conductive body part prevents electrical connection between the electrodes through the at least one droplet. However, the present disclosure is not limited thereto and embodiments are possible in which the electrodes come into direct contact with the at least one droplet.

The at least one droplet may comprise a plurality of droplets. In this case, the plurality of electrodes may comprise a plurality of electrodes for each droplet among the plurality of droplets. The shape, position, and/or orientation of each droplet can preferably be changed independent from the other droplets by appropriately driving the electrodes that are associated with that droplet.

The pick-and-place apparatus may further comprise an inspection unit, such as an optical camera, for determining an orientation and/or position of an electronic component held by the at least one droplet on the first surface of a given pickup tool among the at least one pickup tool. The apparatus may further comprise an alignment controller for controlling the supply unit in dependence of the determined orientation and/or position to adjust the orientation and/or position of the electronic component held by the at least one droplet of liquid by preferably individually shaping, moving, and/or orienting each droplet. This alignment controller is preferably part of or connected to the abovementioned controller.

The liquid droplet unit may comprise a jetting or dripping unit to provide the at least droplet of liquid onto the first surface of a given pickup tool by means of jetting or dripping. Alternatively, the tool body of each pickup tool may comprise at least one channel exiting on the first surface for the formation of the at least one droplet, respectively, each channel being in fluid communication with a reservoir of said liquid. The pick-and-place apparatus may then further comprise, for each pickup tool, a pressure unit, such as a pump, for pumping the liquid through said at least one channel for forming the at least one droplet.

The pick-and-place apparatus may also comprise a second release unit for at least partially removing the at least one droplet for the purpose of releasing the electronic component held by the at least one droplet, wherein the second release unit preferably comprises a light source, such as a laser. If the pickup tool comprises electrodes, the second release unit may comprise one or more heaters for heating the electrodes such that the at least droplet at least partially evaporates. The one or more heaters can be provided on the pickup tool although the present disclosure is not limited thereto. Alternatively, the acceptor substrate and the movable transfer module or the pickup tool and acceptor substrate can be configured to a) move toward each other for the purpose of bringing the electronic component into contact with an adhesive layer on the acceptor substrate causing the adhesive layer to exert a force onto the electronic component that exceeds a force exerted on the electronic component by the at least one droplet, and b) move away from each other for allowing the electronic component to detach from the at least one drop and causing the electronic component to be held by the adhesive layer on the acceptor substrate. For example, the acceptor substrate may be provided with an adhesive layer or spot at the placement position. The adhesive layer or spot may comprise a glue or solder. By moving the pickup tool towards the acceptor substrate, the adhesive layer or spot may exert a force onto the electronic component that exceeds the force by which the at least one droplet holds the electronic component. At this time, the pickup tool can be moved away from the acceptor substrate. The at least one droplet may remain attached to the electronic component after retracting the tool. However, the acceptor substrate is typically held at elevated temperatures to achieve sufficient adhesiveness of the adhesive layer. The elevated temperatures may therefore cause the at least one droplet to evaporate.

The relative movement of the pickup tool and acceptor substrate required for the abovementioned release of the electronic component can be realized by moving the movable transfer module in a first direction whereas the acceptor substrate is not moved in this direction, by moving the acceptor substrate in a direction opposite to the first direction whereas the movable transfer module is not moved in this direction, or by moving both the acceptor substrate and movable transfer module. Instead of moving the movable transfer module in its entirety it may also be possible to move the pickup tool relative to a remainder of the movable transfer module.

The at least one droplet of a liquid may comprise a droplet of water, de-ionized water, alcohol or glycerol.

According to a further aspect of the present disclosure, a method is provided for transferring an electronic component. This method comprises providing a pickup tool that comprises a tool body having a first surface on which at least one droplet of a liquid is arranged, releasing an electronic component from a donor substrate, capturing and holding the released electronic component using the at least one drop of liquid on the first surface, bringing the pickup tool into alignment with an empty placement position on an acceptor substrate, and transferring the electronic component from the pickup tool to the empty placement position. The method may additionally comprise changing the position and/or orientation of the electronic component by changing the shape, position, and/or orientation of the at least one droplet using electrowetting, prior to transferring the electronic component.

### DESCRIPTION OF THE DRAWINGS

So that the manner in which the features of the present disclosure can be understood in detail, a more particular description is made with reference to embodiments, some of which are illustrated in the appended figures. It is to be noted, however, that the appended figures illustrate only typical embodiments and are therefore not to be considered limiting of its scope. The figures are for facilitating an understanding of the disclosure and thus are not necessarily drawn to scale. Advantages of the subject matter claimed will become apparent to those skilled in the art upon reading this description in conjunction with the accompanying figures, in which like reference numerals have been used to designate like elements, and in which:
Figure 1 illustrates an embodiment of a pick-and-place apparatus in accordance with the present disclosure;
Figure 2 schematically illustrates the embodiment of figure 1;
Figure 3 illustrates a pick-up tool to be used in the embodiment of figure 1;
Figure 4 illustrates the manipulation of shape and position of a droplet in accordance with the present disclosure; and
Figure 5 illustrates a method for transferring an electronic component in accordance with the present disclosure.

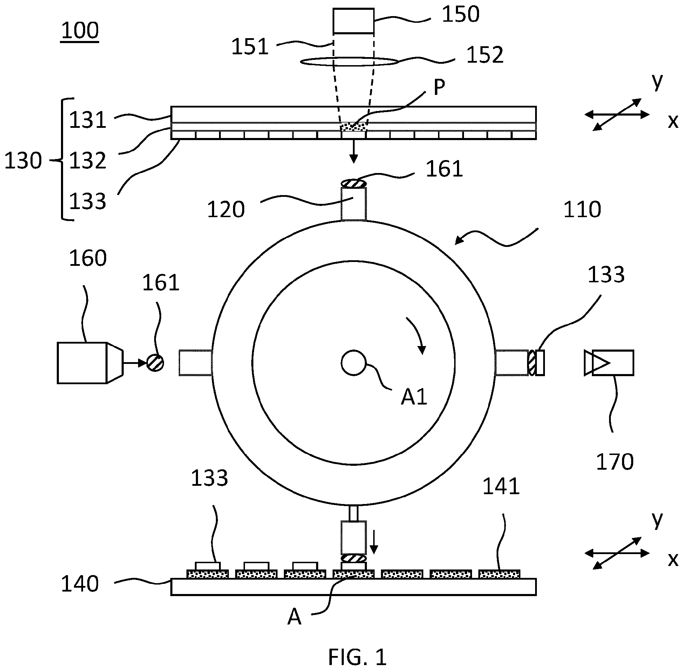

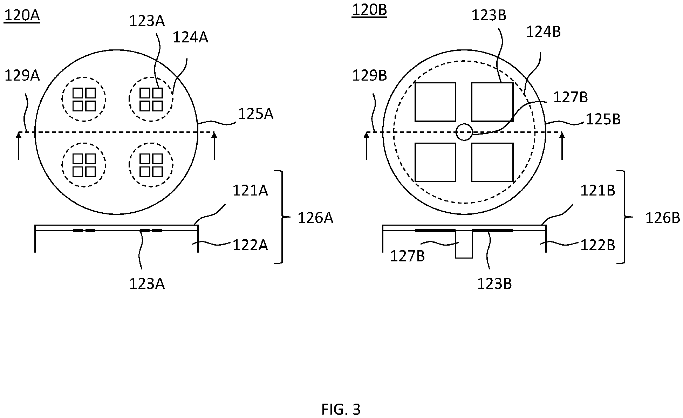

In figure 1, a pick-and-place apparatus 100 is shown in accordance with the present disclosure. It comprises a movable transfer module in the form of a turret 110. In figure 1, turret 110 is provided with four pickup tools 120, of which examples are shown in figure 3. Furthermore, turret 110 can be rotated about an axis A1.

Figure 1 further illustrates a donor substrate 130 provided in the form of a film frame carrier on which a diced semiconductor is arranged. More in particular, donor substrate 130 comprises a film 131 on which an adhesive layer 132 is provided by which semiconductor dies 133 of a diced semiconductor wafer are arranged. Although explained using semiconductor dies 133, apparatus 100 can be configured for transferring other electronic components such as LEDs and passives.

Donor substrate 130 is supported by a donor stage (not shown). A donor stage driver may be used to control the donor stage for moving donor substrate 130. In figure 1, the donor stage is able to move donor substrate 130 in the x-y plane.

Figure 1 further illustrates an acceptor substrate 140 that is supported by an acceptor stage (not shown). An acceptor stage driver may be used to control the acceptor stage for moving acceptor substrate 140. In figure 1, the acceptor stage is able to move acceptor substrate 140 in the x-y plane. A plurality of placement positions A is defined on acceptor substrate 140. At these positions, an adhesive 141 is provided.

Apparatus 100 comprises a liquid droplet unit 160 to provide a droplet 161 of liquid onto pickup tool 120. To this end, liquid droplet unit 160 can be configured to provide droplet 161 by means of jetting or dripping.

Apparatus 100 also comprises a first release unit 150 that comprises a laser source that emits a beam 151 that is focused by a lens 152 onto a donor position P at which a semiconductor die 133 is attached to film 131. As a result of this focusing, adhesive layer 132, which is typically heat-sensitive or light-sensitive, loses its adhesive properties causing semiconductor die 133 to become detached from film 131. As a result of the detachment, semiconductor die 133 will fall downward onto a droplet 161 on a pickup tool 120 that was previously aligned with donor position P. Additionally, or alternatively, absorption of light by adhesive layer 132 may cause this layer to at least partially ablate thereby causing a propelling force that pushes semiconductor die 133 toward pickup tool 120.

Alternatively, apparatus 100 may comprise a mechanical release unit for releasing semiconductor dies 133 from film 131. For example, a movable needle can be used that punches through film 131 on which semiconductor dies 133 are placed. Such needle can be driven using a pneumatic cylinder or the like.

After semiconductor die 133 is caught by droplet 161 on a pickup tool 120, turret 110 is rotated to bring pickup tool 120 into a position in which an image of semiconductor die 133 can be obtained using inspection system 170 that comprises an optical camera. Inspection system 170 determines the position and/or orientation of semiconductor die 133 relative to pickup tool 120.

As a next step, turret 110 is rotated further to bring pickup tool 120 into alignment with a placement position A on acceptor substrate 140. To achieve proper alignment, acceptor substrate 140 may have been moved to bring an empty position into alignment with pickup 120. In addition, acceptor substrate 140 may have been moved to account for a positional offset that was determined using inspection system 170. However, such a correction can additionally or alternatively be performed differently as will be explained later.

After aligning pickup tool 120 and acceptor substrate 140, semiconductor die 133 can be released. As shown in figure 1, pickup tool 120 is moved toward acceptor substrate 140 in such a manner that semiconductor die 133 touches adhesive 141. More in particular, pickup tool 120 is moved such that the force exerted on semiconductor die 133 by adhesive exceeds the force exerted by droplet 161 on semiconductor die 133.

Movement of pickup tool 120 can be realized by moving turret 110 in its entirety. Alternatively, pickup tool 120 can be moved relative to a remainder of turret 110. For example, pickup tool 120 can be connected to a hydraulic cylinder. In a further embodiment, movement of pickup tool 120 is replaced by or complemented with a movement of acceptor substrate 140 toward turret 110.

Once sufficient force is exerted on semiconductor die 133 by adhesive 141, pickup tool 120 can moved back. During this motion, semiconductor die 133 will remain attached to acceptor substrate 140 through adhesive 141 as the latter exerts a stronger force on semiconductor die 133 than droplet 161.

Optionally, droplet 161, or what still remains of droplet 161 on pickup tool 120 after having released semiconductor die 133, may be removed prior to arranging a new droplet 161 by liquid droplet unit 160, for example by means of heating.

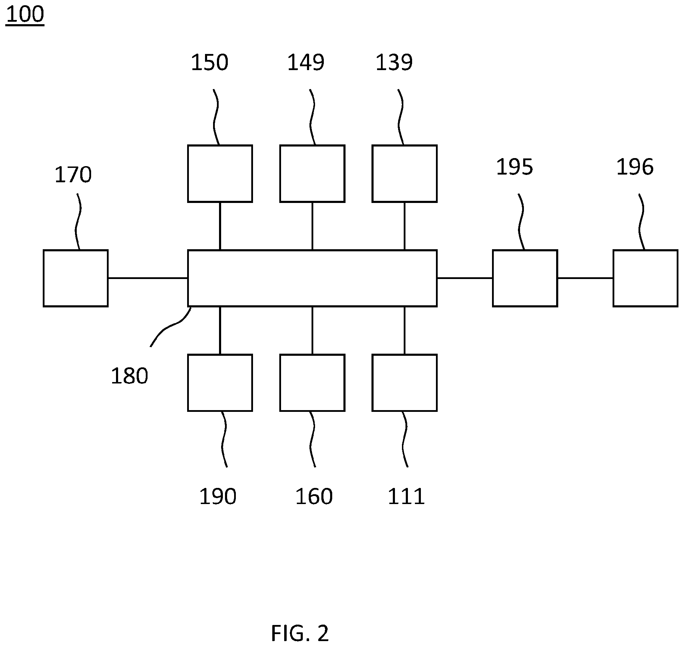

Apparatus 100 is schematically illustrated in figure 2. Apparatus 100 comprises a controller 180 that receives information from inspection system 170. Controller 180 controls liquid droplet unit 160, first release unit 150, an acceptor stage driver 149 that moves an acceptor stage that holds acceptor substrate 140, a donor stage driver 139 that moves a donor stage that holds donor substrate 130, a turret driver 111 for rotating turret 110, and a second release unit 190. This latter release unit may comprise a driver for mutually moving acceptor substrate 140 and pickup tool 120. This driver may comprise a pneumatic cylinder connected to pickup tool 120 and/or the driver may be configured for moving acceptor substrate 140 and/or turret 110. Additionally, or alternatively, second release unit 190 may comprise heating means for heating droplet 161 for the purpose of causing semiconductor die 133 to be released from pickup tool 120 and/or for the purpose of removing what still remains of droplet 161 on pickup tool 120 after having released semiconductor die 133. These heating means may comprise a light source.

Apparatus 100 may further comprise an alignment controller 195 that controls a supply unit 196 and that is controlled by controller 170 to change the position and/or orientation of semiconductor die 133 relative to pickup tool 120. This will be explained referring to figure 3.

On the left, figure 3 illustrates a pickup tool 120A. A top view is shown, as well as a cross-sectional view taken along line 129A. Pickup tool 120A comprises a non-conductive hydrophobic part 121A and a second part 122A, which parts are both comprised by pickup tool body 126A. A side of part 121A defines a first surface 125A of pickup tool 120A. Furthermore, a plurality of electrodes 123A is arranged in between parts 121A and 122A.

Circles 124A indicate intended positions for a droplet 161 of liquid. Put differently, pickup tool 120A is configured to hold semiconductor die 133 using four droplets 161.

By applying a potential difference over electrodes 123A, the wetting properties of first surface 125A can be modified. This will cause droplets 161 arranged at circles 124A to change shape, orientation, and/or position. Consequently, the position and/orientation of a semiconductor die 133 attached to pickup tool 120A using droplets 161 can be changed accordingly.

On the right, figure 3 illustrates a pickup tool 120B. A top view is shown, as well as a cross-sectional view taken along line 129B. Similar to pickup tool 120A, pickup tool 120B comprises a non-conductive hydrophobic part 121B and a second part 122B. A side of part 121A defines a first surface 125B of pickup tool 120B. Furthermore, a plurality of electrodes 123B is arranged in between parts 121B and 122B.

Circle 124B indicates an intended position for a single droplet 161 of liquid. Put differently, unlike pickup tool 120A, pickup tool 120B is configured to hold semiconductor die 133 using a single droplet 161.

Pickup tool 120B further defines a channel 127B through which liquid can be transported for forming a droplet 161 on first surface 125B. For example, channel 127B can be in fluid communication with a reservoir (not shown) of the liquid. A pump may be used for pumping fluid from the reservoir through channel 127B. Such a pump may be provided for each pickup tool 120B separately. In such an embodiment, the liquid droplet unit is not external from turret 110 as shown in figure 1 but may comprise the pump(s) required for pumping the liquid though channels 127B of pickup tools 120B. These pumps may be controlled using controller 180.

It should be noted that the embodiments for pickup tools 120A, 120B may be combined. For example, a pickup tool may have one or more channels for arranging one or more droplets on the first surface of which the shape, position, and/or orientation are controlled using one or more electrodes. When using multiple droplets, such as with pickup tool 120A, sets of electrodes can be defined for each droplet for individually controlling the shape, position, and/or orientation of the droplets. Pickup tool 120A for example has a set of four electrodes 123A for each droplet 161.

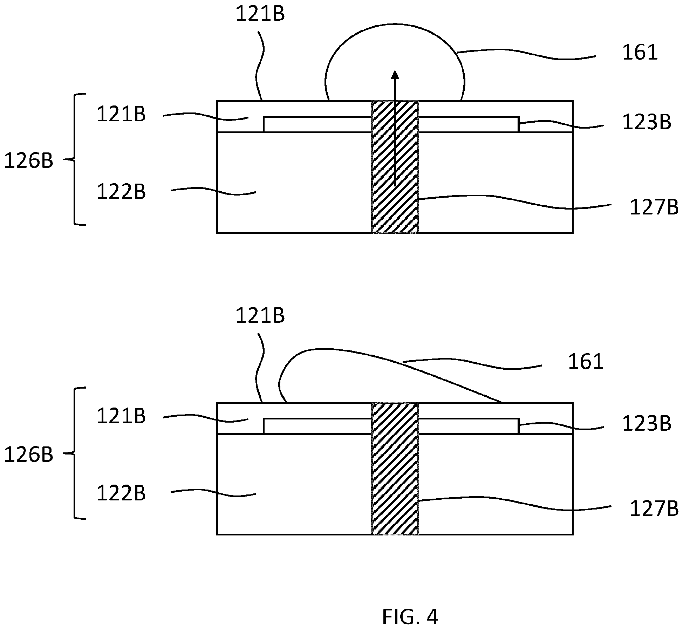

Figure 4 illustrates an example of changing droplet 161 using electrodes 123B for pickup tool 123B. The top figure illustrates the situation after transporting liquid through channel 127B for forming droplet 161 without applying a potential difference over the pair of electrodes 123B. In the bottom figure, a potential difference has been applied over the pair of electrodes 123B causing a deformation of droplet 161 as a result of electrowetting.

Electrodes 123A, 123B can be controlled using supply unit 195 shown in figure 2. Here, it is noted that supply unit 196 may control the potential of each electrode 123A, 123B relative to a reference potential. In an embodiment, the potential of one or more electrodes 123A, 123B may be set to this reference potential. In turn, supply unit 196 is controlled by alignment controller 195 in dependence of the information from inspection system 170.

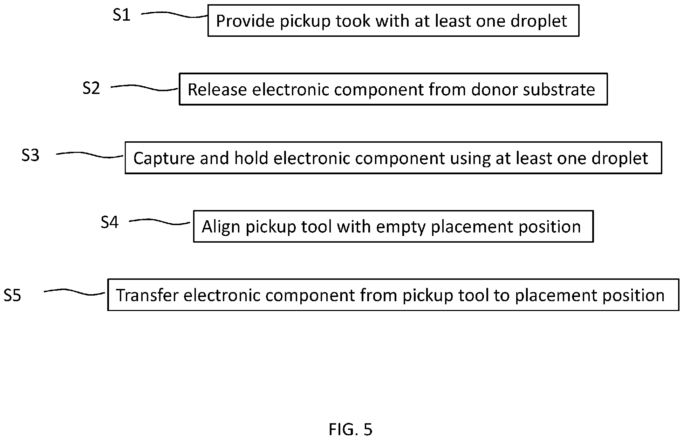

Figure 5 illustrates a method for transferring an electronic component in accordance with the present disclosure. This method comprises a step S1 of providing a pickup tool that comprises a tool body having a first surface on which at least one droplet of a liquid is arranged, and a step S2 of releasing an electronic component from a donor substrate. The method further comprises a step S3 of capturing and holding the released electronic component using the at least one drop of liquid on the first surface, and a step S4 of bringing the pickup tool into alignment with an empty placement position on an acceptor substrate. Finally, the method may comprise a step S5 of transferring the electronic component from the pickup tool to the empty placement position.

The scope of the present disclosure includes any novel feature or combination of features disclosed therein either explicitly or implicitly or any generalization thereof irrespective of whether or not it relates to the claimed invention or mitigate against any or all of the problems addressed by the present invention. The applicant hereby gives notice that new claims may be formulated to such features during prosecution of this application or of any such further application derived therefrom. In particular, with reference to the appended claims, features from dependent claims may be combined with those of the independent claims and features from respective independent claims may be combined in any appropriate manner and not merely in specific combinations enumerated in the claims.

Features which are described in the context of separate embodiments may also be provided in combination in a single embodiment. Conversely, various features which are, for brevity, described in the context of a single embodiment, may also be provided separately or in any suitable sub combination.

The term "comprising" does not exclude other elements or steps, the term "a" or "an" does not exclude a plurality. Reference signs in the claims shall not be construed as limiting the scope of the claims.

## Claims

1. A pick-and-place apparatus (100) for transferring an electronic component from a donor substrate (130) towards an acceptor substrate (140), comprising:
a movable transfer module (110) comprising at least one pickup tool (120; 120A; 120B), wherein each pickup tool is configured for picking up an electronic component (133) and comprises a tool body (126A; 126B) having a first surface (125A; 125B);
a drive unit (111) mechanically coupled to the movable transfer module and configured for moving the transfer module;
a liquid droplet unit (160) to provide, for each pickup tool, at least one droplet of a liquid on the first surface of that pickup tool for allowing an electronic component released from the donor substrate to be captured and held by said at least one droplet of liquid on said first surface.

2. The pick-and-place apparatus according to claim 1, further comprising a first release unit (150) for releasing an electronic component from the donor substrate, and a controller (180) for controlling the liquid droplet unit, the drive unit, and the first release unit;
wherein the first release unit preferably comprises a light source, such as a laser, or a mechanical release unit, such as a movable needle, that is configured to engage the electronic component to thereby release it from the donor substrate.

3. The pick-and-place apparatus according to claim 2, wherein the controller is configured to:
control the liquid droplet unit to provide at least one droplet of a liquid on the first surface of a given pickup tool among said at least one pickup tool;
control the drive unit to bring said given pickup tool into alignment with an electronic component to be released on the donor substrate; and
control the first release unit for releasing said electronic component.

4. The pick-and-place apparatus according to claim 3, wherein the controller is configured to control the drive unit to bring said given pickup tool into alignment with an empty placement position on the acceptor substrate thereby allowing the electronic component, which is held on the first surface of said given pickup tool by the at least one droplet of liquid, to be transferred from said pickup tool to the empty placement position on the acceptor substrate.

5. The pick-and-place apparatus according to any of the previous claims, wherein the drive unit is configured to rotate the transfer module about a rotational axis, and wherein the at least one pickup tool are each configured to pick up an electronic component from a direction that is perpendicular to said rotational axis.

6. The pick-and-place apparatus according to claim 5, wherein the movable transfer module has a cylindrical body of which an axial axis coincides with said rotational axis, and wherein each pickup tool is mounted to the cylindrical body.

7. The pick-and-place apparatus according to any of the previous claims, wherein each pickup tool comprises a plurality of electrodes (123A; 123B) disposed in or on its tool body at or near its first surface, and wherein the pick-and-place apparatus further comprising a supply unit (196) for applying a potential difference over at least one pair of electrodes among the plurality of electrodes for the purpose of shaping, moving, and/or orienting the at least one droplet of liquid on said first surface.

8. The pick-and-place apparatus according to claim 7, wherein the tool body comprises a first body part (121A; 121B), and a second non-conductive hydrophobic body part (122A; 122B), said second non-conductive hydrophobic body part being fixedly connected on a first side thereof to the first body part and a second side thereof forming the first surface, wherein the plurality of electrodes are arranged on the first body part close to the first surface or in between the first body part and second non-conductive hydrophobic body part.

9. The pick-and-place apparatus according to claim 7 or 8, wherein the at least one droplet comprises a plurality of droplets, and wherein said plurality of electrodes comprises a plurality of electrodes for each droplet among the plurality of droplets.

10. The pick-and-place apparatus according to claims 7-9, further comprising:
an inspection unit (170), such as an optical camera, for determining an orientation and/or position of an electronic component held by the at least one droplet on the first surface of a given pickup tool among the at least one pickup tool;
an alignment controller (195) for controlling the supply unit in dependence of the determined orientation and/or position to adjust the orientation and/or position of the electronic component held by the at least one droplet of liquid by preferably individually shaping, moving, and/or orienting each droplet;
wherein, in so far as depending on claim 2, the alignment controller is preferably part of or connected to the controller.

11. The pick-and-place apparatus according to any of the previous claims, wherein the liquid droplet unit comprises a jetting or dripping unit to provide the at least droplet of liquid onto the first surface of a given pickup tool by means of jetting or dripping.

12. The pick-and-place apparatus according to any of the claims 1-9, wherein the tool body of each pickup tool comprises at least one channel (126B) exiting on the first surface for the formation of the at least one droplet, respectively, each channel being in fluid communication with a reservoir of said liquid, the pick-and-place apparatus further comprising, for each pickup tool, a pressure unit, such as a pump, for pumping the liquid through said at least one channel for forming the at least one droplet.

13. The pick-and-place apparatus according to any of the previous claims, further comprising a second release unit (190) for at least partially removing the at least one droplet for the purpose of releasing the electronic component held by the at least one droplet, wherein the second release unit preferably comprises a light source, such as a laser; and/or
wherein the acceptor substrate and the movable transfer module or the pickup tool and acceptor substrate are configured to:
move toward each other for the purpose of bringing the electronic component into contact with the adhesive layer on the acceptor substrate causing the adhesive layer to exert a force onto the electronic component that exceeds a force exerted on the electronic component by the at least one droplet; and
move away from each other for allowing the electronic component to detach from the at least one drop and causing the electronic component to be held by the adhesive layer on the acceptor substrate.

14. A method for transferring an electronic component, comprising:
providing (S1) a pickup tool that comprises a tool body having a first surface on which at least one droplet of a liquid is arranged;
releasing (S2) an electronic component from a donor substrate;
capturing and holding (S3) the released electronic component using the at least one drop of liquid on the first surface;
bringing (S4) the pickup tool into alignment with an empty placement position on an acceptor substrate; and
transferring (S5) the electronic component from the pickup tool to the empty placement position.

15. The method according to claim 14, further comprising changing the position and/or orientation of the electronic component by changing the shape, position, and/or orientation of the at least one droplet using electrowetting, prior to transferring the electronic component.
